# FASCICULE DE BREVET EUROPEEN

(11) **EP 1 550 579 B1**
(45) Date de publication et mention de la délivrance du brevet: **24.08.2011**
(21) Numéro de dépôt: 04293037.0
(22) Date de dépôt: 17.12.2004
(51) Int. Cl.: B60Q 3/02

(54) **Dispositif d'éclairage intérieur pour véhicule automobile**
Beleuchtungsanordnung im Innenraum eines Kraftfahrzeuges
Lighting assembly inside the passenger compartment of vehicles

(30) Priorité: 19.12.2003 FR 0315117
(43) Date de publication de la demande: 06.07.2005
(73) Titulaire: VALEO VISION, 93012 Bobigny Cedex (FR)
(72) Inventeur: Hackenberger, Nathale, 81710 Saix (FR); Can, Jean-Michel, 31250 Revel (FR); Andrieu, Michel, 81660 Pont de l'Arn (FR)
(74) Mandataire: Tran, Chi-Hai

(56) Documents cités:
- EP-A- 1 101 654
- WO-A-01/38841
- WO-A-03/071069
- WO-A-2004/017521
- WO-A-2004/039631
- DE-A- 3 836 572
- DE-A- 19 921 285

## Description

La présente invention a pour objet un dispositif d'éclairage intérieur pour véhicule automobile. Il peut s'agir, par exemple, d'un plafonnier, d'un éclaireur de coffre ou d'un moyen d'éclairage de l'intérieur d'une boite à gants. L'invention s'intéresse plus particulièrement aux moyens pour commander l'allumage ou l'extinction des sources lumineuses de ces dispositifs.

Diverses solutions existent déjà : ainsi, pour les plafonniers, il est connu d'avoir recours à un interrupteur, que l'on met manuellement en position « on » ou « off », suivant que l'on veut allumer ou éteindre le plafonnier. Actionner un interrupteur requiert de positionner le doigt de façon précise sur l'interrupteur, qui est généralement de dimension très petite. Cela peut s'avéré d'autant plus malaisé quand il fait nuit et que la personne qui veut allumer ou éteindre est celui qui conduit le véhicule. Pour l'éclairage de coffres, de boites à gants ou de bas de portières, il existe aussi des moyens de commande automatique de l'allumage des dispositifs destinés à les éclairer, et qui ont recours à des capteurs qui détectent des ouvertures d'ouvrant. Cependant, ce système n'est applicable que pour éclairer l'intérieur de compartiments fermés : on ne peut pas l'utiliser pour un plafonnier, ou l'éclairage d'un compartiment de rangement sans moyens de fermeture. En outre, l'installation de ce type de capteur peut se révéler difficile de mise en oeuvre et/ou d'un coût trop élevé.

L'invention a donc pour but de surmonter les inconvénients précités, en proposant de mettre au point un système de commande de dispositifs d'éclairage intérieur de véhicules qui soit, notamment, plus ergonomique, plus facile d'utilisation, qui puisse être applicable de façon générale à tout dispositif d'éclairage intérieur. Subsidiairement, on cherche également à ce que ce mode de commande soit facile à mettre en oeuvre, et/ou qu'il soit souple dans ses modes de réalisation, et/ou qu'il permette de limiter/réduire au mieux le nombre de ses composants.

L'invention a tout d'abord pour objet un dispositif d'éclairage intérieur de véhicule automobile, ledit système comprenant au moins une source lumineuse contenue au moins en partie dans un boîtier et sous contrôle d'un système de commande sans contact comprenant au moins un capteur de détection capacitif. Ce capteur comprend avantageusement au moins une électrode et éventuellement des moyens électroniques associés, notamment sous forme d'un circuit électronique.

Le principe de fonctionnement d'un tel capteur est le suivant : il s'agit de créer un condensateur entre d'une part une première électrode appartenant au capteur, et une seconde électrode qui va être constituée par la main de l'utilisateur s'approchant de la première électrode, cette main étant reliée de fait à la terre. Quand ces deux électrodes se trouvent face à face, le condensateur ainsi constitué a une capacité qui dépend de la surface des électrodes et un différentiel de potentiel qui dépend de la distance séparant les deux électrodes et des caractéristiques de l'isolant électrique se trouvant entre celles-ci, c'est-à-dire ici l'air ambiant et/ou des parois isolantes du type plastique. Un circuit électronique associé ou appartenant au capteur peut alors mesurer cette capacité et la comparer à une valeur consigne, afin de déclencher ou non, en fonction de cette mesure, la commande d'allumage ou d'extinction du dispositif d'éclairage.

Ce type de capteur est très avantageux, car il permet de déclencher l'allumage du dispositif d'éclairage même la nuit, en évitant à l'utilisateur de tâtonner pour localiser un interrupteur, qui, de fait, n'existe plus avec l'invention. Au lieu d'avoir à viser un interrupteur de petite taille, il suffit que l'utilisateur approche sa main à une distance que l'on peut régler, par exemple à 10 ou 15 cm de l'électrode du capteur, pour déclencher l'allumage. Et l'invention offre une grande liberté dans la configuration et la localisation de cette électrode. Ainsi, l'électrode peut être intégrée ou non au dispositif d'éclairage : elle peut soit être comprise dans le dispositif, soit être disposée à proximité de celui-ci, notamment si elle offre ainsi une meilleure accessibilité.

Un autre grand avantage de l'invention, outre son ergonomie, sa facilité d'utilisation, est le fait qu'on puisse l'appliquer à tout dispositif d'éclairage intérieur, comme par exemple un plafonnier, un éclaireur de bac de porte ou de boite à gants ou de coffre, un éclaireur de cartes, un éclaireur de miroir de courtoisie, un spot de lecture, un éclairage de tout bac ou compartiment de rangement, ou un éclaireur de trappes sous plancher. En effet, le capteur choisi dans le cadre de l'invention n'impose pas qu'il y ait un ouvrant dans la zone à éclairer. L'invention est ainsi particulièrement adaptée aux compartiments de rangement ouverts.

Comme mentionné plus haut, l'invention permet beaucoup de variantes concernant la réalisation de l'électrode du capteur : celle-ci peut fonctionner à travers quantités de matériaux non conducteurs, par exemple à travers une glace en verre ou plastique, à travers un boîtier en plastique, en bois ou en céramique. Elle peut prendre une forme de type bidimensionnelle (plaque ...) ou tridimensionnelle (fil, lame, introduction de composants conducteurs dans un support qui ne l'est pas ou peu). Un composant du dispositif, s'il est métallique ou suffisamment conducteur, peut jouer en outre le rôle d'électrode au sens de l'invention.

Le document US 2002/0024713 présente les caractéristiques du préambule de la revendication 1.

Selon un premier exemple, le dispositif selon l'invention comprend un logement comprenant au moins une source lumineuse susceptible d'émettre de la lumière, éventuellement au travers d'une glace optionnelle, l'électrode du capteur étant un revêtement conducteur recouvrant tout ou partie des parois internes ou externes du boîtier ou de la glace. Généralement, la glace est prévue avec des sources de lumières traditionnelles du type lampes à filament, alors qu'elle peut être inutile avec des sources de lumière du type diodes électroluminescentes. On choisit par exemple un dépôt d'une couche métallique, par exemple en aluminium, en cuivre, en nickel ou alliage métallique contenant au moins un de ces métaux, ou tout autre matériau suffisamment conducteur. Son épaisseur est par exemple comprise entre 0,5 micron et 0,1 mm. On peut utiliser différentes techniques pour réaliser ce dépôt de revêtement conducteur, par exemple un dépôt de métallisation sous vide (évaporation, pulvérisation cathodique), un dépôt électrolytique ou électrochimique, un dépôt mécanique (on peut par exemple avoir recours à un rouleau recouvert de ou constitué par un métal tendre du type laiton, étain, qui, par frottement contre le substrat à recouvrir va déposer à sa surface une couche dudit métal), ou l'utilisation d'une peinture conductrice ou d'un vernis conducteur (dépôt par projection, pulvérisation, enduction laminaire...). On peut ainsi choisir de dissimuler l'électrode, en la déposant sur une paroi interne ou arrière du boîtier ou d'un autre composant non transparent/non visible du dispositif d'éclairage. On peut aussi préférer rendre visible l'électrode, en la déposant sur une face externe, visible du boîtier ou d'un autre composant substantiellement non transparent/opaque du dispositif, ou sur l'une des faces d'un composant substantiellement transparent (et visible) du dispositif, comme la glace protectrice de la ou des sources lumineuses du dispositif si elle existe. L'électrode peut alors participer au design du dispositif, par exemple en prenant la forme d'un dépôt d'un revêtement dont les contours seront sous la forme d'un logo ou d'un motif décoratif. L'électrode du capteur peut aussi être sous forme d'un revêtement conducteur disposé à proximité du dispositif, de façon visible ou non.

Selon un second exemple, l'électrode du capteur est sous forme d'un ou plusieurs fils conducteur(s) disposé(s) dans ou sur un composant du dispositif, comme le boîtier ou la glace, ou à proximité du dispositif. Ce fil peut être extrudé et faire partie intégrante d'un composant du dispositif, du boîtier par exemple.

Selon un troisième exemple, l'électrode du capteur est sous forme d'une ou plusieurs lame(s) disposée(s) dans ou sur un composant du dispositif, comme le boîtier ou la glace. On peut fixer ces lames au composant par exemple par clippage ou surmoulage. La lame peut aussi être disposée à proximité dudit dispositif.

Selon un quatrième exemple, la ou les sources lumineuses sont une ou plusieurs diodes électroluminescentes fixées à un support, et l'électrode du capteur est sous forme d'un élément conducteur solidarisé audit support. Il peut s'agir d'une piste de cuivre sur le circuit imprimé associé aux diodes, du type PCB. L'électrode peut aussi être solidarisée au circuit de commande électronique du capteur. Ce circuit peut être commun avec le circuit imprimé des diodes électroluminescentes ou non.

Utiliser des diodes comme sources lumineuses est avantageux par ailleurs, car elles ont une longue durée de vie, consomment peu d'énergie et sont compactes. Bien sûr, l'invention peut aussi avoir recours à des sources lumineuses plus traditionnelles du type lampes à filament.

Selon l'invention, l'électrode est intégrée à ou déposée à un réflecteur associé à la ou aux source(s) lumineuse(s). Le réflecteur peut être entièrement métallique, ou être en matériau plastique recouvert d'un revêtement métallique réfléchissant, et jouer de fait le rôle d'électrode, en plus de son rôle optique.

Selon un exemple, l'électrode fait partie intégrante du dispositif d'éclairage, par incorporation de particules conductrices au sein d'une matrice essentiellement polymérique (plastique) d'un composant dudit dispositif, par exemple du boîtier. On peut introduire ces charges conductrices lors de la fabrication du composant, localement, ou elles peuvent être réparties, de façon homogène, dans tout le composant en question.

Un véhicule peut contenir plusieurs dispositifs d'éclairage intérieur, et il peut donc être intéressant de concevoir un système de commande commun à plusieurs dispositifs. Selon un mode de réalisation de l'invention, le système de commande est partagé avec au moins un autre dispositif d'éclairage intérieur du véhicule le capteur capacitif étant un capteur partagé multi commande.

Selon un second mode de réalisation, le système de commande est partagé avec au moins un autre dispositif d'éclairage intérieur de véhicule, à l'aide d'un microcontrôleur, chaque dispositif ayant son capteur de détection. Dans ce cas, le microcontrôleur est apte à échantillonner les dispositifs à commander : les électrodes sont reliées en « grappe » au microcontrôleur central et au schéma électrique, qui est unique (ce qui signifie que chaque capteur est connecté individuellement au système de commande électronique). Un échantillonnage rapide des électrodes par le microcontrôleur permet de savoir si les dispositifs doivent être activés ou non.

L'invention a également pour objet le procédé de mise en oeuvre du dispositif décrit plus haut. Plusieurs modes de fonctionnement sont possibles :

Un premier mode de fonctionnement de la commande de l'éclairage consiste à allumer la ou des sources lumineuse(s) quand la main de l'utilisateur s'approche, son retrait laissant la ou les sources allumée(s). C'est un mode de fonctionnement de type « On/Off ». Il faut que la main s'approche à nouveau pour éteindre le dispositif.

Un second mode de fonctionnement de la commande de l'éclairage consiste à allumer la ou des sources lumineuse(s) quand la main de l'utilisateur s'approche, son retrait provoquant l'extinction de la ou des sources lumineuse(s).

Un troisième mode de fonctionnement de la commande de l'éclairage consiste à allumer pour une période de temps brève la ou des sources lumineuse(s) quand la main de l'utilisateur s'approche. Le dispositif reste ainsi allumé juste pour un « pulse » lorsque la main s'approche.

Un quatrième mode de fonctionnement la commande de l'éclairage consiste à allumer la ou des sources lumineuse(s) quand la main de l'utilisateur s'approche pour une durée prédéterminée.

On peut aussi prévoir différents modes d'extinction des sources lumineuses : l'extinction de la ou des sources lumineuses peut se fait progressivement ou en tout ou rien.

Bien sûr, ce ne sont que des exemples de fonctionnement non limitatifs. On peut aussi proposer à l'utilisateur un moyen de préréglage lui permettant de choisir ou modifier le mode de fonctionnement du dispositif.

L'invention a également pour objet le véhicule muni d'un tel dispositif.

L'invention sera détaillée ci-après avec des exemples non limitatifs, à l'aide des figures suivantes :
- **fig.1-1ba** : une représentation schématique des différences entre l'art antérieur et la solution selon l'invention
- **fig. 2 à 6** : des représentations schématiques d'un mode de réalisation selon l'invention et d'exemples

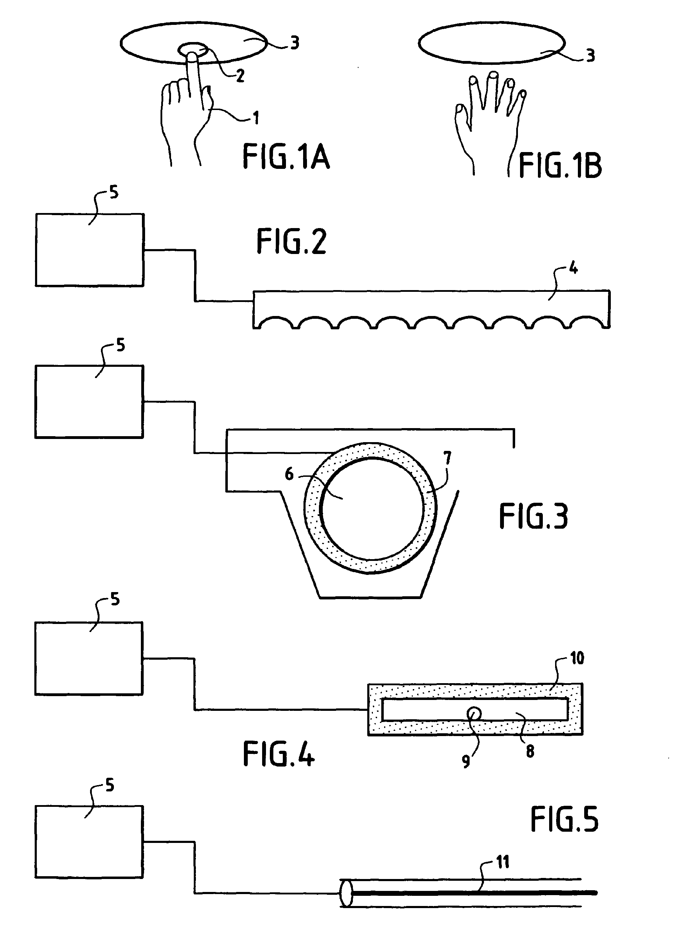

La figure 1a correspond à l'art antérieur : il fallait que la main 1 appuie de façon précise sur l'interrupteur 2 pour allumer ou éteindre, par exemple, un plafonnier 3. La figure 1b correspond à une solution selon l'invention : il suffit que la main 1 s'approche du plafonnier 3 pour que celui-ci s'allume ; ce qui permet un plus grand confort d'utilisation, notamment pour le conducteur du véhicule.

Les figures 3 à 5 présentent de façon très simplifiée les différents exemples pour réaliser l'électrode du capteur capacitif d'un plafonnier:

En figure 2, est représenté le réflecteur 4 du plafonnier, qui joue le rôle de l'électrode du capteur capacitif de l'invention, en étant relié électriquement de façon appropriée à un circuit intégré de commande 5, le réflecteur peut être en métal réfléchissant ou en matériau non conducteur du type plastique recouvert d'un revêtement réfléchissant conducteur. On utilise ainsi un composant existant du dispositif pour être électrode au sens de l'invention. Le réflecteur ayant une surface significative, l'électrode peut être « activé » à une distance de plusieurs cm.

En figure 3, est représenté en vue de face un plafonnier muni d'une glace 6, qui est entourée d'un dépôt métallique 7 constituant l'électrode du capteur et relié de façon appropriée à un circuit 5,

En figure 4, est représentée un support 8 de circuit imprimé supportant une diode 9 servant de source lumineuse à un plafonnier, avec une piste de cuivre 10 additionnelle constituant l'électrode du capteur capacitif, toujours reliée à un circuit 5,

En figure 5, est représenté un fil 11 qui peut être gainé ou surmoulé sur tout composant du plafonnier et relié de façon approprié au circuit de commande 5.

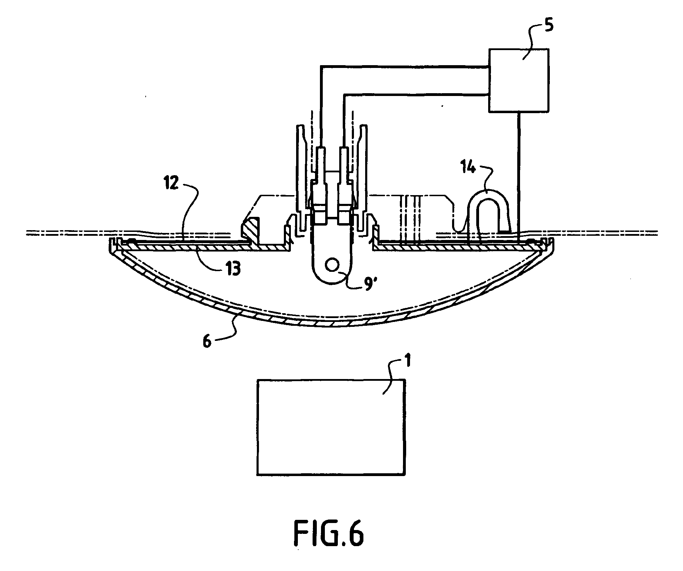

La figure 6 est une représentation plus détaillée, en coupe, d'un éclaireur de bac de porte selon l'invention : la zone 12, à l'arrière du boîtier 13 du plafonnier, est métallisée afin de constituer l'électrode du capteur capacitif selon l'invention. Elle se trouve donc ici sous forme d'un anneau suivant le profil de la paroi arrière 13 du boîtier, qui peut être circulaire ou ovoïde. En fait, de façon plus générale, le revêtement peut avoir les contours d'une surface elliptique trouée en son centre, pour permettre l'introduction de la lampe et des moyens de connexion. Ce revêtement peut avoir aussi tout autres contour approprié. Dans le cas présent, il a été déposé à la surface de la paroi 13 en plastique par métallisation sous vide, il est en aluminium et il a une épaisseur de quelques microns. L'éclaireur est également muni d'une glace en plastique 6, d'une diode électroluminescente 9. L'électrode 12 est reliée à un circuit de commande 5, qui utilise des moyens électroniques pour mesurer la capacité du condensateur constitué par l'électrode 12 et la main 1, symbolisée par un rectangle, qui s'approche. Des moyens 14 de fixation sont prévus pour fixer le dispositif au panneau du véhicule, notamment par clippage. On ne rentre pas dans le détail du circuit de commande, qui est à la portée de l'homme de l'art. Dans le cas de la figure 6, on a donc une électrode invisible pour l'utilisateur, sans composant supplémentaire coûteux, complexe ou encombrant. Comme la surface du revêtement est de l'ordre de 40 cm², il remplit son rôle de détection que la main s'approche du plafonnier à une distance de 10 cm, voire 15 cm : l'utilisateur n'a pas besoin d'approcher la main très près pour activer le capteur, ce qui est pratique la nuit avec de mauvaises conditions de visibilité dans l'habitacle du véhicule.

On gagne en compacité, et en ergonomie, avec une fiabilité de fonctionnement élevé.

On peut aussi noter que le système de commande 5 peut être délocalisé par rapport à l'emplacement du capteur et du dispositif, comme cela a été représenté sous la référence 5 aux figures 2 à 6, mais qu'il est également possible de prévoir un circuit de commande intégré, notamment avec le capteur et son circuit électronique, dans le dispositif d'éclairage.

## Revendications

1. Dispositif d'éclairage intérieur de véhicule automobile, tel que ledit dispositif comprend au moins une source lumineuse contenue au moins en partie dans un boîtier et sous contrôle d'un système de commande sans contact comprenant au moins un capteur de détection capacitif comprenant une électrode intégrée au dispositif, ledit dispositif comprenant un logement comprenant au moins une source lumineuse susceptible d'émettre de la lumière au travers d'une glace, **caractérisé en ce que** l'électrode du capteur capacitif est intégrée à ou déposée sur un réflecteur associé à la ou aux source(s) lumineuse(s).

2. Dispositif selon la revendication 1, **caractérisé en ce que** le capteur capacitif comprend des moyens électroniques et une électrode intégrée audit dispositif d'éclairage.

3. Dispositif selon l'une des revendications précédentes, **caractérisé en ce qu'**il s'agit d'un plafonnier, d'un éclaireur de bac de porte ou de boite à gants ou de coffre, ou d'un éclaireur de cartes, ou d'un éclaireur de miroir de courtoisie, d'un spot de lecture, d'un éclairage de tout bac ou compartiment de rangement, ou d'un éclaireur de trappes sous plancher.

4. Dispositif selon l'une des revendications précédentes, **caractérisé en ce que** le système de commande est partagé avec au moins un autre dispositif d'éclairage intérieur du véhicule et ence que le capteur capacitif est un capteur partagé multi commande.

5. Dispositif selon l'une des revendications 1 à 3, **caractérisé en ce que** le système de commande est partagé avec au moins un autre dispositif d'éclairage intérieur de véhicule, à l'aide d'un microcontrôleur, chaque dispositif ayant son capteur de détection.

6. Procédé de mise en oeuvre du dispositif selon l'une des revendications précédentes, **caractérisé en ce que** la commande de l'éclairage se fait par allumage de la ou des sources lumineuse(s) quand la main de l'utilisateur s'approche, son retrait lassant la ou les sources allumée(s), ou **en ce que** la commande de l'éclairage se fait par allumage de la ou des sources lumineuse(s) quand la main de l'utilisateur s'approche, son retrait provoquant l'extinction de la ou des sources lumineuse(s), ou **en ce que** la commande de l'éclairage se fait par allumage bref de la ou des sources lumineuse(s) quand la main de l'utilisateur s'approche, ou **en ce que** la commande de l'éclairage se fait par allumage de la ou des sources lumineuse(s) quand la main de l'utilisateur s'approche pour une durée prédéterminée.

7. Procédé selon la revendication 6, **caractérisé en ce que** l'extinction de la ou des sources lumineuses se fait progressivement ou en tout ou rien.

8. Véhicule automobile **caractérisé en ce qu'**il est muni du dispositif selon l'une au moins des revendications 1 à 5.

## Claims

1. Interior lighting device for a motor vehicle, such that the said device comprises at least one source of light which is contained at least partly in a housing, and is under the control of a contactless control system comprising at least one capacitive detection sensor comprising an electrode which is integrated in the device, the said device comprising a receptacle comprising at least one source of light which can emit light through glass, **characterised in that** the electrode of the capacitive sensor is integrated with, or deposited on, a reflector which is associated with the source(s) of light.

2. Device according to claim 1, **characterised in that** the capacitive sensor comprises electronic means, and an electrode which is integrated with the said lighting device.

3. Device according to one of the preceding claims, **characterised in that** it is a ceiling light, a light for a door pocket, or a glove compartment or a boot, or a map light, or a vanity mirror light, a reading light, a light for any storage compartment or pocket, or a light for under-floor hatches.

4. Device according to one of the preceding claims, **characterised in that** the control system is shared with at least one other interior lighting device of the vehicle, and **in that** the capacitive sensor is a shared multiple-control sensor.

5. Device according to one of claims 1 to 3, **characterised in that** the control system is shared with at least one other interior lighting device of the vehicle by means of a microcontroller, each device having its own detection sensor.

6. Method for implementation of the device according to one of the preceding claims, **characterised in that** the lighting is controlled by switching on of the source(s) of light when the hand of the user approaches it, withdrawal of the hand leaving the source(s) lit, or **in that** the lighting is controlled by switching on of the source(s) of light when the hand of the user approaches it, withdrawal of the hand giving rise to switching off of the source(s) of light, or **in that** the lighting is controlled by brief switching on of the source(s) of light when the hand of the user approaches it, or **in that** the lighting is controlled by switching on of the source(s) of light when the hand of the user approaches it for a predetermined period of time.

7. Method according to claim 6, **characterised in that** the source(s) of light is/are switched off gradually or all at once.

8. Motor vehicle, **characterised in that** it is provided with the device according to at least one of claims 1 to 5.

## Patentansprüche

1. Innenraumbeleuchtungsvorrichtung für ein Kraftfahrzeug, wobei die Vorrichtung wenigstens eine Lichtquelle umfasst, die wenigstens zum Teil in einem Gehäuse enthalten und von einem berührungslosen Bediensystem gesteuert ist, das wenigstens einen kapazitiven Erfassungssensor mit einer in der Vorrichtung integrierten Elektrode umfasst, wobei die Vorrichtung eine Aufnahme mit wenigstens einer Lichtquelle umfasst, die Licht durch eine Scheibe hindurch zu emittieren vermag,
**dadurch gekennzeichnet, dass** die Elektrode des kapazitiven Sensors in einem der bzw. den Lichtquelle(n) zugeordneten Reflektor integriert oder auf einem solchen aufgebracht ist.

2. Vorrichtung nach Anspruch 1,
**dadurch gekennzeichnet, dass** der kapazitive Sensor elektronische Mittel und eine in die Beleuchtungsvorrichtung integrierte Elektrode umfasst.

3. Vorrichtung nach einem der vorhergehenden Ansprüche,
**dadurch gekennzeichnet, dass** es sich um eine Dachhimmelbeleuchtung, eine Türtaschen- oder Handschuhfach- oder Kofferraumbeleuchtung oder eine Kartenleseleuchte oder eine Schminkspiegelleuchte, eine Spot-Leseleuchte, eine Gepäckraum- oder Ablagefachbeleuchtung oder eine Bodenablagefächerbeleuchtung handelt.

4. Vorrichtung nach einem der vorhergehenden Ansprüche,
**dadurch gekennzeichnet, dass** das Bediensystem mit wenigstens einer anderen Innenraumbeleuchtungsvorrichtung des Fahrzeugs gemeinsam genutzt wird und dass der kapazitive Sensor ein gemeinsam genutzter Mehrfachbedienungssensor ist.

5. Vorrichtung nach einem der Ansprüche 1 bis 3,
**dadurch gekennzeichnet, dass** das Bediensystem mit wenigstens einer anderen Innenraumbeleuchtungsvorrichtung des Fahrzeugs mit Hilfe eines Microcontrollers gemeinsam genutzt wird, wobei jede Vorrichtung ihren eigenen Erfassungssensor hat.

6. Verfahren zur Verwendung der Vorrichtung nach einem der vorhergehenden Ansprüche,
**dadurch gekennzeichnet, dass** das Betätigen der Beleuchtung durch Einschalten der Lichtquelle(n) bei Annäherung der Hand des Nutzers erfolgt, wobei beim Entfernen der Hand die Lichtquelle(n) eingeschaltet bleibt, oder dass das Betätigen der Beleuchtung durch Einschalten der Lichtquelle(n) bei Annäherung der Hand des Nutzers erfolgt, wobei das Entfernen der Hand das Erlöschen der Lichtquelle(n) bewirkt, oder dass das Betätigen der Beleuchtung durch kurzes Einschalten der Lichtquelle(n) bei Annäherung der Hand des Nutzers erfolgt, oder dass das Betätigen der Beleuchtung durch Einschalten der Lichtquelle(n) bei Annäherung der Hand des Nutzers für die Dauer einer vorbestimmten Zeit erfolgt.

7. Verfahren nach Anspruch 6,
**dadurch gekennzeichnet, dass** das Erlöschen der Lichtquelle(n) allmählich oder als Ein-Aus-Funktion erfolgt.

8. Kraftfahrzeug,
**dadurch gekennzeichnet, dass** es mit der Vorrichtung nach wenigstens einem der Ansprüche 1 bis 5 ausgestattet ist.
